# EUROPEAN PATENT APPLICATION

(11) **EP 0 544 470 A1**
(43) Date of publication of application: **02.06.1993**
(21) Application number: 92310627.2
(22) Date of filing: 20.11.1992
(51) Int. Cl.: H01L 21/336, H01L 21/265

(54) **Thin film transistor, method of fabricating the same and ion implantation method used in the fabrication**

(30) Priority: 20.11.1991 JP 304573/91; 30.01.1992 JP 14473/92; 06.08.1992 JP 210302/92; 17.11.1992 JP 307350/92
(71) Applicant: SHARP KABUSHIKI KAISHA, Osaka 545 (JP)
(72) Inventor: Yoshinouchi, Atsushi, Kashiba-shi, Nara-ken (JP); Morita, Tatsuo, Soraku-gun, Kyoto (JP); Tsuchimoto, Shuhei, Kitakatsuragi-gun, Nara-ken (JP)
(74) Representative: White, Martin David

(57) **Abstract**

A method of the invention of fabricating a thin film transistor (20') on an insulating substrate (13) includes a step of forming a polysilicon film (14) on the insulating substrate (13); and an ion implantation step of exciting, in a magnetic field, ions (21) including hydrogen ions and ions of an element selected from the group consisting of the III, IV, V groups of the periodic system, and for simultaneously implanting the hydrogen ions and the selected element ions into the polysilicon film (14) to form at least one of a source (15) and a drain (16) region in the polysilicon film (14).

## Description

### BACKGROUND OF THE INVENTION

### 1. Field of the Invention:

The present invention relates to a thin film transistor and a method of fabricating the same, and to an ion implantation method used in such fabrication.

### 2. Description of the Related Art:

Recently, an apparatus such as an image sensor or a liquid crystal display has been developed in which a drive circuit is provided on one and the same substrate. As a result, there has been an increase in demand for fabricating thin film transistors on a transparent insulating substrate. Since image sensors, liquid crystal displays, and the like have become large-sized and the productivity thereof has been improved, the substrate on which thin film transistors are formed has become large. Accordingly, a semiconductor fabrication apparatus is desired which is capable of handling a substrate having a large area.

An extremely important step among the process steps for fabricating a semiconductor device is a step for introducing impurities into a semiconductor layer. The impurities can be introduced by thermal diffusion or ion implantation, for example. Using thermal diffusion, the impurities are introduced from the surface of the semiconductor layer. Using ion implantation, impurity ions are implanted. The ion implantation method provides a more precise control of total dopant concentration and a depth to which the impurities are implanted into the semiconductor layer. Moreover, when the ion implantation technique is used, impurities can be shallowly implanted into the semiconductor layer, and impurities can be implanted into the semiconductor layer through thin films which are formed on the semiconductor layer. Furthermore, ion implantation can be performed at low temperatures at which a glass substrata will not deform. For the above reasons, ion implantation is most often used for introducing impurities into a semiconductor layer.

Using a conventional ion implantation apparatus, ions are implanted using an ion beam having a diameter of only several millimeters. When the ions are to be implanted over a large substrate using the above conventional ion implantation apparatus, it is necessary to either move the substrate mechanically or scan the ion beam electrically over the substrate because the area of the substrate is large as compared to the diameter of the ion beam. The provision of a mechanical moving means or an electrical scanning means causes a problem in that the ion implantation apparatus becomes complicated, large-sized and expensive.

One technique for solving the above problem and in which ions can be implanted into a large area is disclosed in Japanese Laid-Open Patent Publication No. 63-194326. According to this technique, ions generated by using a plasma discharge as the ion source are accelerated at a low voltage without mass separating them, and are implanted into a substrate which has been heated to a predetermined temperature in a shower-like shape. The ion implantation in a shower-like shape means that ions are implanted over the semiconductor layer at a time.

Generally, when impurities are introduced into a semiconductor layer using an ion implantation apparatus, it is necessary to anneal the ion-implanted semiconductor layer, in order to maintain an appropriate conductivity of the semiconductor layer. Also, in a case where the technique disclosed in Japanese Laid-Open Patent Publication No. 63-194326 is used for implanting impurities into a thin polycrystalline silicon (hereinafter, referred to as polysilicon) film so as to form thin film transistors, it is necessary to anneal the thin polysilicon film at a high temperature in order to activate the implanted impurities.

Since thin film transistors are formed on a transparent insulating substrate, the transparent insulating substrate must have a heat resistance so as not to deform even at the annealing temperature. For this reason, quartz, which has a high heat resistance, is used as a material of the transparent insulating substrate. However, quartz is very expensive and a quartz substrate is difficult to make in larger sizes. On the other hand, a glass substrate is inexpensive and is easy to make in larger sizes, but the glass substrata will soften at a temperature of 600°C or higher. Therefore, when a glass substrate is used, it is preferable to fabricate the semiconductor devices at a temperature of 600°C or lower. At a temperature of 600°C, however, it takes about 20 hours to perform the annealing for activation after the ion implantation, which causes a problem in that the fabrication process is very time consuming.

It is known that when a transistor is fabricated using a thin polysilicon film as a channel layer, dangling bonds of silicon atoms which exist at grain boundaries in the channel region of the thin polysilicon film adversely affect the transistor characteristics. By terminating the dangling bonds with hydrogen, a source-to-drain current during an off state is decreased, a threshold voltage is lowered, and an ON/OFF ratio (comparing the source-to-drain current during an on state to the source-to-drain current during an off state) is improved. This results in the improvement in the transistor characteristics.

For example, a hydrogenation technique is disclosed in Japanese Laid-Open Patent Publication No. 63-119269. According to the disclosed technique, hydrogen ions of a dose of from 1 x 10¹⁷ to 1 x 10²⁰ ions/cm² are accelerated at an acceleration voltage of 10 keV or lower, and are implanted into the channel region of the transistor. It is also disclosed that in order to effectively terminate the dangling bonds with hydrogen, it is necessary to perform annealing after the ion implantation. However, the hydrogen ions which have been implanted during hydrogenation leave from the polysilicon at about 400°C.

Therefore, when hydrogenation is to be performed after implanting impurities, the hydrogenation should be performed after the annealing at a relatively high temperature (about 600°C) for activating the implanted impurities. Furthermore, in order to effectively terminate the dangling bonds with hydrogen, it is necessary to perform annealing at a relatively low temperature after implanting hydrogen ions. This means that it is necessary to perform both the ion implantation and the annealing twice.

Moreover, in a case where a CMOS transistor is to be fabricated, in order to form a p-region and an n-region, one of the two regions must be covered with a resist so that ions may not be implanted in that region when ions are implanted into the other region. Since the covering resist has a low heat resistance, the resist should be removed before annealing. Therefore, when a CMOS transistor is fabricated, it is also necessary to perform patterning of a resist for ion implantation twice. As a result, the fabrication process becomes complicated.

In an active matrix type liquid crystal display having thin film transistors in a pixel portion, the larger the display portion, the longer the corresponding gate bus line and source bus line. In order to prevent the resistance of the gate bus and source bus lines from increasing, a metal having a low resistance, e.g., containing aluminum or the like, is used as a material for fabricating the lines. It is preferable that a gate electrode is formed simultaneously with the gate bus line using the same metal, whereby the fabrication process of the thin film transistor is simplified. However, in order to attain good transistor characteristics, it is preferable to form source and drain regions in a self-aligned manner. For this purpose, it is necessary to perform ion implantation and activation annealing after forming the gate electrode.

If the gate electrode is formed of aluminum, however, the aluminum reacts with an insulating film or a semiconductor substrate in annealing after the ion implantation, because the melting point of aluminum is low. Therefore, the gate electrode cannot be formed of aluminum, and should be formed using a different material from that of the gate bus line, which results in a complicated fabrication process.

### SUMMARY OF THE INVENTION

According to one aspect of the present invention, a method of fabricating a thin film transistor on an insulating substrate is provided, the method including a step of forming a polysilicon film on the insulating substrate; and an ion implantation step of exciting, in a magnetic field, ions including hydrogen ions and ions of an element selected from the group consisting of the III, IV, and V groups of the periodic system, and for simultaneously implanting the hydrogen ions and the selected element ions into the polysilicon film to form at least one of a source and a drain region in the polysilicon film.

According to another aspect of the present invention, a thin film transistor formed on an insulating substrate is provided including: a polysilicon film formed on the insulating substrate; a gate insulating film formed on the polysilicon film; a gate electrode formed on the gate insulating film; and source and drain regions in the polysilicon film, the source and drain regions being formed in a self-aligned manner by simultaneously implanting hydrogen ions and ions of an element selected from the group consisting of the III, IV and V groups of the periodic system into the polysilicon film using the gate electrode as a mask.

According to still another aspect of the present invention, a method of introducing impurities into a semiconductor is provided, the method including an ion implantation step for simultaneously implanting ions including hydrogen ions and ions of an element selected from the III, IV and V groups of the periodic system into the semiconductor.

Thus, the invention described herein makes possible the following advantages:
(1) A step of annealing after ion implantation is not required, and a glass substrate which is inexpensive and can be easily made to have a large area can be used as a transparent insulating substrate. As a result, the cost of the fabricated product can be lowered, and the fabrication process can be simplified so as to shorten the fabrication time.
(2) After the ion implantation, only hydrogen ions are successively implanted into a channel region of a thin film transistor gate, so that the dangling bonds of silicon atoms which exist at grain boundaries of polysilicon are terminated with hydrogen. As a result, the characteristics of a thin film transistor can be improved, and the fabrication process can be simplified so as to shorten the fabrication time.
(3) The gate electrode of the thin film transistor can be made of aluminum or of a metal containing aluminum. As a result, the gate bus line can be simultaneously formed with the formation of the gate electrode, and the fabrication process can be simplified so as to shorten the fabrication time.

These and other advantages of the present invention will become apparent to those skilled in the art upon reading and understanding the following detailed description with reference to the accompanying figures.

### BRIEF DESCRIPTION OF THE DRAWINGS

Figure **1** is a sectional schematic view showing an ion implantation apparatus in accordance with the present invention.

Figures **2A** and **2B** are sectional views showing a thin film transistor according to an example of the present invention.

Figure **3** is a plan view showing a liquid crystal display apparatus using a thin film transistor according to an example of the present invention.

Figure **4** is a graph showing a relationship between a specific resistance of a polysilicon film after implanting ions into the polysilicon film and a concentration of PH₃ contained in a material gas used in the ion implantation, under conditions explained in Examples 1 to 4 in accordance with the present invention.

Figure **5** is a graph showing a relationship between a total dose of implanted ions and a ratio of PH₃ gas to the total material gas, when the ions are implanted under conditions explained in Example 5 in accordance with the present invention.

Figure **6** is a graph showing a relationship between a ratio of activated ions to the total dose of implanted ions and a ratio of PH₃ gas to the total material gas, when the ions are implanted under conditions explained in Example 5 in accordance with the present invention.

Figure **7** shows a variation in a current density of all the kinds of ions which is obtained by varying a high frequency power applied to a plasma source of the ion implantation apparatus shown in Figure **1**, when the ion implantation apparatus is used for implanting ions in accordance with the invention.

Figure **8** is a graph showing a relationship between a dose of implanted hydrogen ions and a threshold voltage of a transistor, when the hydrogen ions are implanted under conditions explained in Example 6 in accordance with the invention.

### DESCRIPTION OF THE PREFERRED EMBODIMENTS

The present invention will now be described with reference to the drawings, wherein like reference numerals are used to refer to like elements throughout.

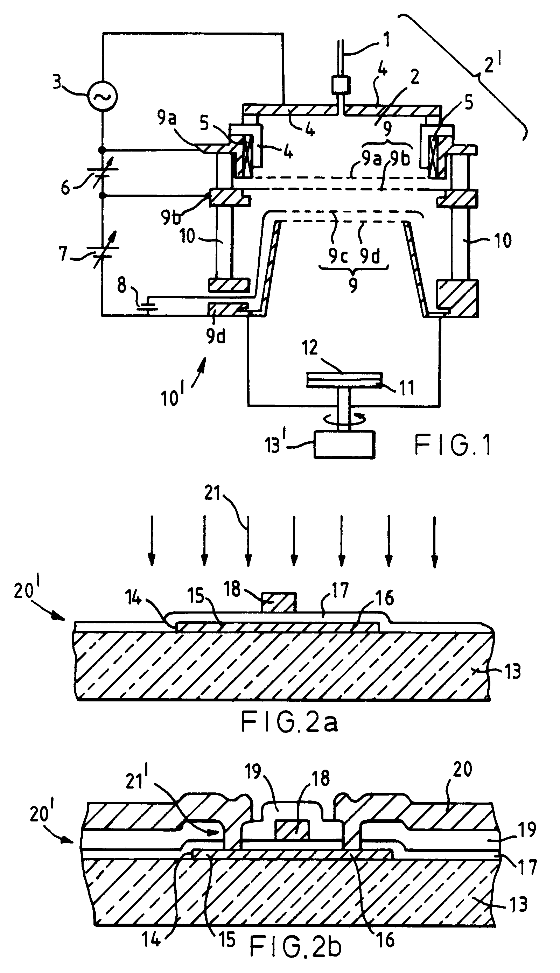

Figure **1** is a sectional schematic view of an ion implantation apparatus **10'** used in accordance with the present invention. The ion implantation apparatus **10'** shown in Figure **1** includes a plasma source **2'** for generating ions, an ion accelerator **9** for accelerating the generated ions, and a substrate holder **11** for holding a substrate **12**.

The plasma source **2'** includes a cylindrical chamber **2** for keeping a plasma, and high frequency electrodes **4** provided on a top and along the side of the cylindrical chamber **2**. The high frequency electrode **4** on the top of the cylindrical chamber **2** has a diameter of 60 cm, although an electrode **4** with a different diameter certainly is within the intended scope of the invention. A high frequency power supply **3** for exciting a plasma is connected to the high frequency electrodes **4**. A gas inlet **1** for introducing a gas for forming the plasma as an ion source is provided in a center of the high frequency electrode **4** on the top of the cylindrical chamber **2**. A magnet **5** is provided on the outside of the high frequency electrode **4** on the side of the cylindrical chamber **2** so as to aid effective generation of ions and to adjust the shape of the plasma. In the exemplary embodiment, a high frequency electric power of 13.56 MHz is applied to the high frequency electrodes **4** at 0 to 200 Watts (W) from the high frequency power supply **3**. The pressure in the cylindrical chamber **2** is maintained in the range of 2 to 10 x 10⁻⁴ Torr using known techniques. Thus, a plasma is generated and the introduced gas is partially ionized in the cylindrical chamber **2**.

The ion accelerator **9** comprises electrode plates **9a**, **9b**, **9c** and **9d** disposed parallel to each other. These four electrode plates **9a**, **9b**, **9c** and **9d** respectively have mesh-type electrodes and terminals for applying voltage. The first electrode plate **9a** is provided at a bottom of the cylindrical chamber **2**. The four electrode plates **9a**, **9b**, **9c** and **9d** are insulated and are kept at appropriate intervals therebetween by an insulator **10**. A first ion acceleration power supply **6** is connected between the first and the second electrode plates **9a** and **9b**. A voltage caused by the first ion acceleration power supply **6** derives the ions generated at the plasma source **2'** into the ion accelerator **9**. A second ion acceleration power supply **7** and a deceleration power supply **8** are connected between the second and the third electrode plates **9b** and **9c**. A voltage caused by the second ion acceleration power supply **7** further accelerates the derived ions. The ions are accelerated and proceed vertically downward (relative to Figure **1**) to the electrode plates **9a**, **9b**, **9c** and **9d**. A deceleration power supply **8** for controlling secondary electrons is also connected between the third and the fourth electrode plates **9c** and **9d**.

The substrate **12** is mounted on the substrate holder **11**, and the substrate **12** is irradiated with the ions accelerated in the ion accelerator **9**. The distance between the fourth electrode plate **9d** and the substrate **12** is about 50 cm in the exemplary embodiment. The ion implantation apparatus **10'** of the present invention is provided with a rotation mechanism **13'** for rotating the substrate holder **11** so that the ions will be implanted into the substrate generally uniformly as will be appreciated.

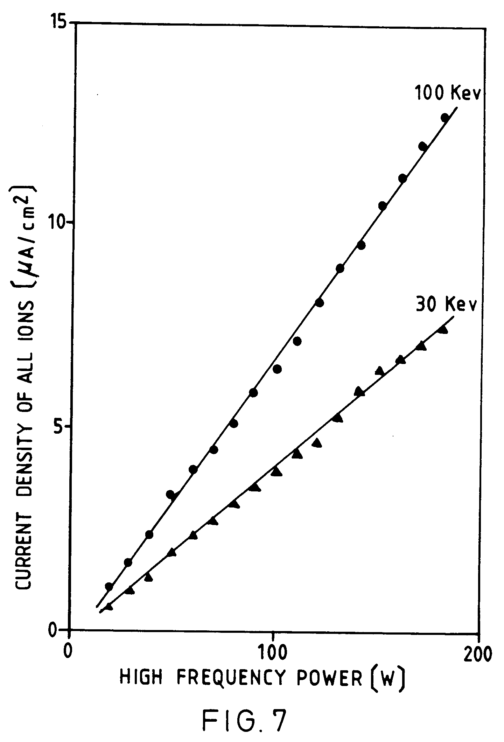

The manner in which the ion implantation apparatus **10'** shown in Figure **1** controls a dose of implanted ions will now be described. As shown in Figure **7**, when a high frequency electric power of 13.56 MHz is applied to the high frequency electrodes **4** at 0 to 200 W from the high frequency power supply **3**, and the acceleration voltage for the second ion acceleration power supply **7** is assumed to be 100 keV and 30 keV, respectively, a current density caused by the resultant kinds of ions implanted into the substrate **12** is in proportion to the high frequency power applied to the high frequency electrodes **4**. If gases of PH₃ and H₂ are introduced via the gas inlet **1** as the ion source, a dose of implanted phosphorus ions is in proportion to the current density caused by all the kinds of implanted ions generated by the PH₃ and H₂ gases. Therefore, by appropriately adjusting the high frequency power, it is possible to control the dose of phosphorus ions to be implanted.

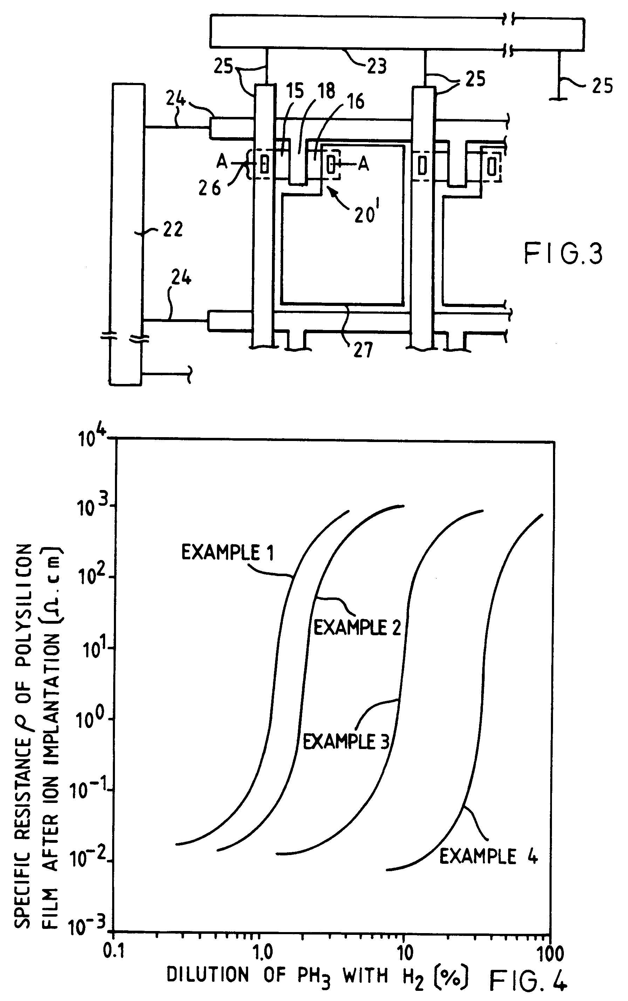

Next, referring to Figures **2A**, **2B** and **3**, a method of fabricating a thin film transistor **20'** according to the present invention is described. Figures **2A** and **2B** show sectional views taken along a line A-A in Figure **3** at the completion of different steps as will be further described herein.

As a transparent insulating substrate **13** for supporting the thin film transistor **20'**, a quartz substrate, a glass substrate which will not deform when heated at 600°C as in conventional devices, or a glass substrate which has a low deforming point can be used. The "deforming point" referred to herein means the highest temperature at which the substrate **13** will not deform. Also, a glass having a low deforming point as referred to herein is a glass having a deforming point of 450°C or higher, and preferably in the range of 450°C to 600°C. As is shown in Figure **2A**, a polysilicon film **14** having a thickness of 50 to 150 nanometers (nm) is formed and patterned on a transparent insulating substrate **13**. Then, a silicon oxide film **17** having a thickness of about 100 nm is deposited as a gate insulating film. Then, a gate electrode **18** having a thickness of about 200 to 300 nm and a gate bus line **24** having a thickness of about 200 to 300 nm as are shown in Figure **3** are simultaneously formed. The gate electrode **18** and the gate bus line **24** can be formed using a single-layer metal film of Al or AlSi or a two-layer metal film of Ti/Al or Ti/AlSi, for example. In order to lower the resistance of the gate bus line, it is especially preferable to use a metal containing Al.

Next, in the ion implantation apparatus **10'** shown in Figure **1**, the transparent insulating substrate **13** shown in Figure **2A** is mounted on the substrate holder **11**, and ion implantation is performed. As is shown in Figure **2A**, ions **21** containing impurity ions and hydrogen ions are simultaneously implanted into the substrate **13**. Because the gate electrode **18** serves as an implantation mask, a source **15** and a drain **16** are formed in the polysilicon film **14** in a self-aligned manner. The source **15** and drain **16** are also shown in Figure **3**. In this step, the annealing for activating impurity ions is not performed.

Then, after the above ion implantation, only hydrogen ions are implanted into a portion of polysilicon film **14** under the gate electrode **18**. This implantation of hydrogen ions is successively performed after the ion implantation of ions **21** without taking the substrate **13** out of the ion implantation apparatus **10'** shown in Figure **1**. The implantation is performed at an energy level of 20 to 30 keV, and the dose is 2 x 10¹⁵ to 2 x 10¹⁶ ions/cm². It is sufficient that the implantation energy is set to be a level at which hydrogen ions can penetrate the silicon oxide film **17** and the gate electrode **18**. Before the implantation of hydrogen ions, the substrate temperature is measured to be a room temperature. During the ion implantation, the temperature at the surface of the substrate **13** may rise up to 300°C depending on the ion current density. Such a difference in substrate temperature has been found not to cause a significant difference in the effect of the hydrogenation.

Then, as is shown in Figure **2B**, a silicon oxide film **19** having a thickness of about 500 nm is formed as an interlevel insulating film by atmospheric-pressure chemical vapor deposition with the substrate temperature at 430°C. Contact holes **21'** are then formed through the silicon oxide film **19** for connecting the source **15** and drain **16** with a lead electrode **20.** Then, the lead electrode **20** is formed by sputtering at a room temperature. As a result of the above process steps, transistor portions **26** and gate bus lines **24** are formed. In this example, all the process steps after the ion implantation are performed at a temperature of 450°C or lower.

The active matrix type liquid crystal display apparatus shown in representative port in Figure **3** includes, in addition to the transistor portions **26** and the gate bus lines **24**, a gate drive circuit **22**, a source drive circuit **23**, source bus lines **25** and pixel portions **27**. The gate drive circuit **22** selects one of the plural gate bus lines **24**, and a signal voltage is applied from the source drive circuit **23** to a liquid crystal capacitance via the source bus lines **25**, so as to perform a liquid crystal display.

In Examples 1 through 6, which are explained below, experimental results when ion implantation is performed using a thin film transistor fabricated by the above fabrication process are provided.

### Example 1

Ion implantation was performed using a mixed gas of PH₃ and H₂ as a material gas introduced via gas inlet **1** to form a plasma in the cylindrical chamber **2**, and the transparent insulating substrate **13** was mounted on the substrate holder **11**, so that an n-channel thin film transistor was fabricated on the transparent insulating substrate **13**. The acceleration voltage for the second ion acceleration power supply **7** is assumed to be 100 keV and the current density caused by all the kinds of implanted ions generated by the PH₃ and H₂ gases is applied in the range of 1 to 10 µA/cm². A high frequency electric power of 13.56 MHz is applied to the high frequency electrodes **4** at 100 to 200 W from the high frequency power supply **3**. Figure **4** shows a variation in specific resistance of the polysilicon film by varying the concentration ratio of PH₃ to H₂, in a case where an ion dose of phosphorus was 5 x 10¹⁴ ions/cm².

In Figure **4**, the horizontal axis represents a dilution of PH₃ gas with hydrogen, and the vertical axis represents a specific resistance of the polysilicon in the source and drain regions after the ion implantation. The polysilicon film after the implantation of impurities turns into an amorphous state because the impurities and the silicon are not bonded, which causes the specific resistance to increase. However, the impurities and the silicon are bonded by activation means such as annealing, so that the polysilicon turns into a polycrystalline state, which causes the specific resistance to decrease. As is seen from the above facts, the specific resistance is an indicator for indicating the crystal state of silicon.

In this example, the following fact was found. If impurities and a large amount of hydrogen were simultaneously implanted, polysilicon was amorphous directly after the start of the implantation. The polysilicon gradually turned to polycrystalline and the specific resistance was lowered. During the implantation, the substrate temperature rose up to 300°C. However, at a temperature of such a degree, the impurities implanted by the conventional implantation technique cannot be activated. Therefore, it is seen that the increase in substrate temperature during the ion implantation does not eliminate the need for the annealing step for activating the implanted impurities.

As seen from Figure **4** and the curve corresponding to Example 1, in particular, when the concentration of PH₃ gas is reduced to 2% or lower (i.e., when the hydrogen concentration is 98% or higher), the specific resistance greatly decreases. Especially when the concentration is 1% or lower, i.e., when the hydrogen concentration is 99% or higher, the value of the specific resistance indicates that it is not necessary to anneal the semiconductor layer for activation. That is, the silicon is perfectly in the polycrystalline state. In this example, it is possible to attain a uniform specific resistance of ± 8% within a sample substrate with a size up to 30 cm x 30 cm. On the other hand, when the concentration of PH₃ gas is higher than 2%, i.e., when the concentration of H₂ gas is 98% or lower, the specific resistance is high, whereby it is necessary to anneal the semiconductor layer for activation.

### Example 2

This example was conducted under the same conditions as those of Example 1 except that the ion dose of phosphorus was 2 x 10¹⁵ ions/cm², and the result is shown in the corresponding curve in Figure **4**. In this example, when the concentration of PH₃ gas was 3% or lower, i.e., when the concentration of H₂ gas was 97% or higher, the specific resistance was low and a polycrystalline silicon was obtained. Also, the same degree of uniformity in specific resistance within the substrate was attained as in Example 1, and a polysilicon film having a large area was obtained.

### Example 3

This example was conducted under the same conditions as those of Example 1 except that the ion dose of phosphorus was set to be 1 x 10¹⁶ ions/cm², and the result is shown in the curve labeled Example 3 in Figure **4**. In this example, when the concentration of PH₃ gas was 10% or lower, i.e., when the concentration of H₂ gas was 90% or higher, the specific resistance was low and a polycrystalline silicon was obtained. Also, the same degree of uniformity in specific resistance within the substrate was attained as in Example 1, and a polysilicon film having a large area was obtained.

### Example 4

This example was conducted under the same conditions as those of Example 1 except that the ion dose of phosphorus was 5 x 10¹⁶ ions/cm², and the result is shown in the corresponding curve in Figure **4**. In this example, when the concentration of PH₃ gas was 20% or lower, i.e., when the concentration of H₂ gas was 80% or higher, the specific resistance was low and a polycrystalline silicon was obtained. Also, the same degree of uniformity in specific resistance within the substrate was attained as in Example 1, and a polysilicon film having a large area was obtained.

### Example 5

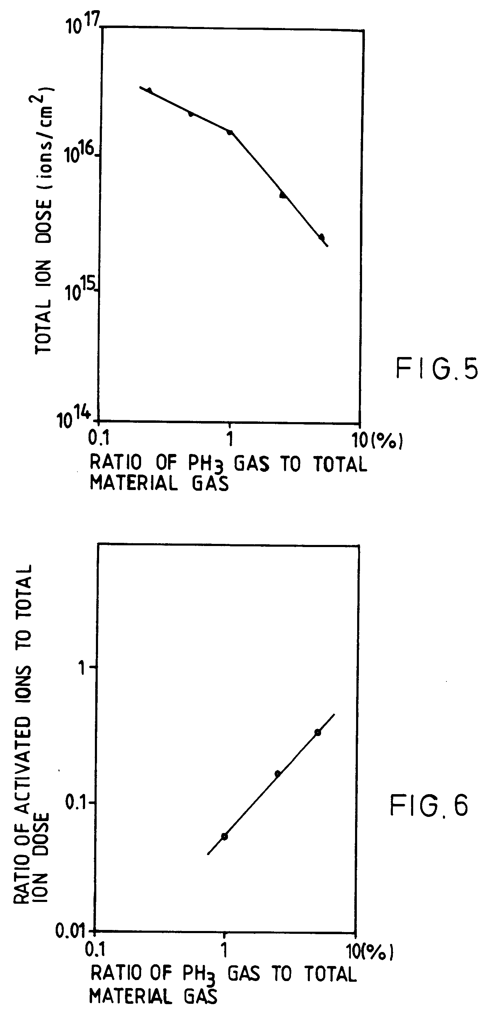

In this example, ions were implanted into a polysilicon film with a thickness of 300 nm under such conditions that the hydrogen dilution of PH₃ gas was varied in the range of 0.25 to 5% (i.e., the concentration of H₂ gas was varied in the range of 99.75 to 95%), the high frequency power was 100 W, and the acceleration energy wag 100 keV. Then, the polysilicon film was annealed at 600°C for 20 hours in a nitrogen atmosphere. The annealed polysilicon film was examined as to the specific resistance thereof. In this example, a glass substrate which would not deform at 600°C was used so as not to deform during the annealing at 600°C. Figure **5** shows a relationship between a total dose of implanted ions and a ratio of PH₃ gas to the total material gas, in a case where the specific resistance of the polysilicon film is 3 x 10⁻² Ω·cm. Figure **6** shows a relationship between a ratio of activated ions to the total dose of implanted ions and a ratio of PH₃ gas to the total material gas.

As is seen from Figure **5**, in a region where the ratio of PH₃ gas to the total material gas is 1% or lower, i.e., where the ratio of H₂ gas to the total material gas is 99% or higher, the absolute value of the slope of the graph line is smaller than in the other region. This means that when the ratio of PH₃ gas is 1% or lower, i.e., when the ratio of H₂ gas is 99% or higher, the effect attained by simultaneously implanting the hydrogen gas is remarkable. Therefore, in Examples 1 to 4 described above, it is preferable that the ratio of PH₃ gas be set to be 1%, or lower, i.e., it is preferable that the ratio of H₂ gas be set to be 99% or higher.

As is seen from Figure **6**, the ion dose to be implanted can be controlled by adjusting the ratio of PH₃ gas.

### Example 6

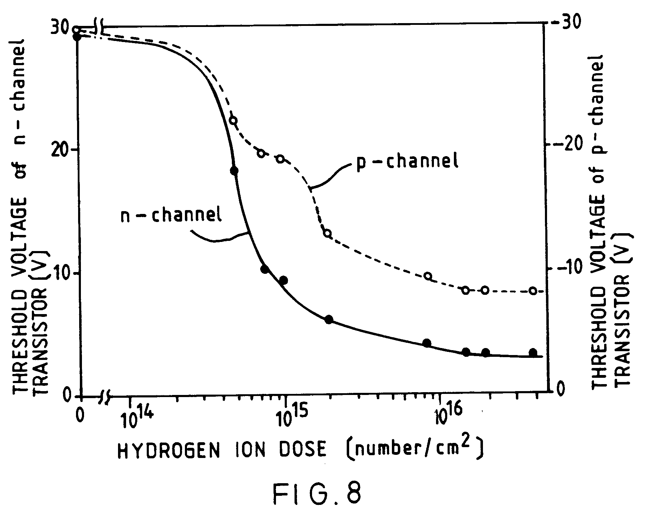

Figure **8** shows the dependency of the threshold voltages of n-channel and p-channel transistors (L/W = 7 µm/5 µm ; wherein L denotes a channel length, and W denotes a channel width) on a dose of implanted hydrogen ions for hydrogenation. If the hydrogenation is performed after implanting impurity ions, the threshold voltages are reduced. When the implant dose is 2 x 10¹⁵ ions/cm² or larger, the characteristics are significantly improved. When the implant dose is 2 x 10¹⁶ ions/cm² or larger, a saturation tendency is exhibited. If hydrogen ions of a dose in a range of 2 x 10¹⁵ to 2 x 10¹⁶ ions/cm² are implanted, a source·drain current during an OFF state of the transistor is reduced to several picoamperes. Accordingly, the ratio of a current during the ON state of the transistor to a current during the OFF state of the transistor is improved to be 10⁶ or higher.

As seen from Examples 1 to 6 above, in order to obtain a polysilicon film in a sufficiently activated state without an anneallng step after the ion implantation, it is necessary to increase an implant dose of phosphorus ions. If the concentration of PH₃ gas is increased, the activation efficiency is deteriorated. However, when the implant dose of phosphorus ions is larger than 5 x 10¹⁶ ions/cm², the activation efficiency of the implanted phosphorus ions is poor, and inactivated ions will have a detrimental influence.

If the implant dose of phosphorus ions is smaller than 5 x 10¹⁴ ions/cm², the specific resistance of the polysilicon film is not sufficiently lowered. Therefore, preferably, the implant dose is in the range of 5 x 10¹⁴ to 5 x 10¹⁶ ions/cm ², and more preferably, the implant dose is in the range of 1 x 10¹⁵ to 1 x 10¹⁶ ions/cm². Moreover, in order to improve the activation efficiency without annealing in view of the productivity, it is preferable to set the current density caused by all the kinds of ions generated by the PH₃ gas, including hydrogen ions to be 1 µA/cm².

A material gas from which impurities are generated preferably includes hydrogen ions and ions of an element selected from the group consisting of the III, IV and V groups of the periodic system, and more preferably is selected from B₂H₆, SiH₄, Si₂H₆, PH₃ and the like which are diluted with hydrogen. By using these gases, the same effects as described above can be attained. Therefore, a p-channel transistor can be fabricated using a B₂H₆ gas by the same fabricating process. By implanting SiH₄ or Si₂H₆ simultaneously with a hydrogen gas into the amorphous silicon film, the amorphous silicon film can be made into a polycrystalline silicon film. In this case, also, it is unnecessary to anneal the substrate after the ion implantation. Moreover, the substrate temperature will not rise up to a degree which adversely affects the glass plate during the ion implantation.

According to the conventional ion implantation method, ions generated by the ion source are allowed to pass through a mass spectrometer to eliminate ions unnecessary to the ion implantation, and only the selected ions are accelerated and implanted. In this conventional case, most of the implanted ions are not positioned in a lattice, and the ions have low carrier movability. Therefore, it is necessary to heat-treat the ions at a high temperature, so as to activate them. Especially when impurities are introduced into polysilicon by ion implantation, the polysilicon turns into amorphous due to a damage by implantation, so that the specific resistance rapidly rises (to 10³ Ω·cm or higher). When the amorphous silicon is turned into polycrystalline silicon by annealing the amorphous silicon, the implanted impurities are taken into the silicon crystals to produce carriers. Therefore, it has been necessary to perform annealing after ion implantation to activate the ions.

According to the invention, hydrogen ions and impurity ions are simultaneously implanted into a semiconductor layer. As a result, it is possible to attain a high carrier movability without annealing after the ion implantation.

The hydrogen ions and impurity ions are simultaneously implanted into a polysilicon film by an ion shower doping method, so that a thin film transistor is fabricated at a temperature of 450°C or lower after the ion implantation. This means that the thin film transistor can easily be fabricated on a glass substrate which has a low deforming point. Since this fabrication process does not necessitate an annealing step after the ion implantation, the following effects can be attained.

First, the fabrication process can be simplified and the fabrication time can be shortened even by a process at 450°C or lower.

Additionally, the characteristics of a thin film transistor can be improved by implanting only hydrogen ions of a dose in the range of 2 x 10¹⁵ to 2 x 10¹⁶ ions/cm² into a channel of the thin film translator successively after the ion implantation and by terminating dangling bonds of silicon atoms which exist at grain boundaries of polysilicon with hydrogen. Moreover, by setting the dose of implanted hydrogen ions in the above range, the implant energy of hydrogen is relatively small, whereby the possibility of damage to the ion implantation apparatus can be reduced.

Furthermore, as a material of a gate electrode of the thin film transistor, aluminum or a metal containing aluminum can be used. Therefore, gate bus lines can be simultaneously formed with the formation of the gate electrode, so that the fabrication process is simplified and the fabrication time can be shortened.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

## Claims

1. A method of fabricating a thin film transistor on an insulating substrate, the method comprising:
a step of forming a polysilicon film on the insulating substrate; and
an ion implantation step of exciting, in a magnetic field, ions including hydrogen ions and ions of an element selected from the group consisting of the III, IV, and V groups of the periodic system, and for simultaneously implanting the hydrogen ions and the selected element ions into the polysilicon film to form at least one of a source and a drain region in said polysilicon film.

2. A method according to claim 1, wherein the thin film transistor is fabricated at a temperature of 450°C or lower, after the ion implantation process.

3. A method according to claim 1, wherein, in the ion implantation step, a hydrogen concentration of a material gas for generating the selected element ions and the hydrogen ions is 80% by volume or higher, and a dose of the selected element ions implanted into the polysilicon film is in the range of 5 x 10¹⁴ ions/cm² to 5 x 10¹⁶ ions/cm².

4. A method according to claim 3, wherein the hydrogen concentration of the material gas is 99% by volume or higher.

5. A method according to claim 1, wherein the method further comprises the steps of:
forming a gate insulating film on the polysilicon film after the step of forming the polysilicon film on the insulating substrate;
forming a gate electrode on the gate insulating film; and
implanting hydrogen ions of a dose in the range of 2 x 10¹⁵ ions/cm² to 2 x 10¹⁶ ions/cm² into a portion of the polysilicon film under the gate electrode after the ion implantation step.

6. A thin film transistor formed on an insulating substrate, the thin film transistor comprising:
a polysilicon film formed on the insulating substrate;
a gate insulating film formed on the polysilicon film;
a gate electrode formed on the gate insulating film; and
source and drain regions in the polysilicon film,
the source and drain regions being formed in a self-aligned manner by simultaneously implanting hydrogen ions and ions of an element selected from the group consisting of the III, IV and V groups of the periodic system into the polysilicon film using the gate electrode as a mask.

7. A thin film transistor according to claim 6, wherein the gate electrode is formed of a metal containing aluminum.

8. A thin film transistor according to claim 7, wherein the insulating substrate is a glass substrate having a deforming point of 450°C or higher.

9. A method of introducing impurities into a semiconductor, the method comprising an ion implantation step for simultaneously implanting ions including hydrogen ions and ions of an element selected from the III, IV and V groups of the periodic system into the semiconductor.

10. A method according to claim 9, wherein a hydrogen concentration of a material gas for generating the selected element ions and the hydrogen ions is 80% by volume or higher.

11. A method according to claim 9, wherein the semiconductor is polysilicon.

12. A method according to claim 9, wherein the semiconductor is amorphous silicon.
